# EUROPÄISCHE PATENTSCHRIFT

(11) **EP 2 803 252 B1**
(45) Veröffentlichungstag und Bekanntmachung des Hinweises auf die Patenterteilung: **25.10.2017**
(21) Anmeldenummer: 13700982.5
(22) Anmeldetag: 04.01.2013
(51) Int. Cl.: H05K 7/20, H02M 7/00

(54) **LEISTUNGSELEKTRONIKMODULSYSTEM MIT EINGEBAUTER KÜHLVORRICHTUNG**
POWER ELECTRONICS MODULE SYSTEM WITH BUILT-IN COOLING SYSTEM
SYSTÈME DE MODULE D'ÉLECTRONIQUE DE PUISSANCE AVEC SYSTÈME DE REFROIDISSEMENT INCORPORÉ

(30) Priorität: 22.02.2012 DE 102012202673
(43) Veröffentlichungstag der Anmeldung: 19.11.2014
(73) Patentinhaber: Siemens Aktiengesellschaft, 80333 München (DE)
(72) Erfinder: TRODLER, Dirk, 90489 Nürnberg (DE); SCHOTT, Peter, 90491 Nürnberg (DE)
(74) Vertreter: Dr. Gassner & Partner mbB
(86) Internationale Anmeldenummer: PCT/EP2013/050100
(87) Internationale Veröffentlichungsnummer: WO 2013/124080

(56) Entgegenhaltungen:
- EP-A2- 2 101 402
- US-A1- 2003 133 267

## Beschreibung

Die Erfindung betrifft ein Leistungselektronikmodulsystem.

Leistungselektronikmodule weisen mindestens einen Stromrichter auf, mit Hilfe dessen in der Regel Spannungen und Ströme wechsel- oder gleichgerichtet werden können. Leistungselektronikmodule werden, z.B. in der Automobilindustrie, zum Ansteuern von elektrischen Motoren verwendet und wandeln z.B. die Batteriespannung der Batterie des Autos in eine Wechselspannung zur Ansteuerung des Elektromotors, der das Auto antreibt, um.

Der Stromrichter benötigt dabei eine Kühlung, die die beim Betrieb des Stromrichters anfallenden energetischen Verluste aufnimmt und abführt. Der Stromrichter ist über Lastromleitungen, die im Gegensatz zu Steuerleitungen, eine hohe elektrische Leistung übertagen, z.B. bei einem Elektroauto, mit dem Elektromotor und der Batterie, verbunden. Die Laststromleitungen sind dabei fachüblich über elektrische Kontakte mit dem Stromrichter direkt verbunden. Durch die hohen elektrischen Ströme welche in den Lastromleitungen fließen, erwärmen sich die Laststromleitungen und die elektrischen Kontakte, was zu einer zusätzlichen Erwärmung des Stromrichters führt. Die Wärme der Lastromleitungen wird über die elektrischen Kontakte an den Stromrichter übertragen. Weiterhin wird auch die in den elektrischen Kontakten entstehende Wärme an den Stromrichter übertragen. Die hierdurch entstehende zusätzliche Erwärmung des Stromrichters führt zu einer Verringerung der Leistungsfähigkeit und Lebensdauer des Stromrichters.

Die Lastromleitungen und deren Zuleitungsrichtung zu dem Leistungselektronikmodul sind häufig, insbesondere in der Automobilindustrie, bei den einzelnen Automobilherstellern unterschiedlich ausgestaltet, so dass bisher zur Herstellung der elektrisch leitenden Laststromverbindungen zwischen den elektrischen Laststromleitungen und dem Leistungselektronikmodul, die elektrischen Lastanschlüsse des Leitungselektronikmoduls individuell an die Erfordernisse des betreffenden Automobilherstellers angepasst werden müssen, was einen hohen Aufwand erfordert. Insbesondere in der Automobilindustrie ist es deshalb für einen Hersteller des Leistungselektronikmoduls wünschenswert für unterschiedliche Automobilhersteller ein einheitliches Leistungselektronikmodul herstellen zu können.

Aus der EP 1 265 282 A2 ist eine Schaltungsanordnung mit einem Grundkörper mit mindestens einem Substrat, dem ein zu kühlendes Wechselanschlusselement zugeordnet ist, bekannt.

EP 2 101 402 A2 offenbart einen wassergekühlten elektrischen Leistungsumwandler nach dem Oberbegriff des Anspruchs 1. Die Halbleiterelemente des Leistungsumwandlers werden dabei von beiden Seiten mit einem Wasserkanal gekühlt.

US 2003/0133267 A1 beschreibt ein Leistungsmodul mit einer Wasserkühlung, wobei die Kühlkanäle in vorteilhafter weise die Halbleiterelemente kühlen.

Es ist Aufgabe der Erfindung ein Leistungsmodulsystem zu schaffen, das eine gute Kühlung eines Stromrichters eines Leistungsmoduls, sowie die Verwendung eines einheitlichen Leistungsmoduls ermöglicht.

Diese Aufgabe wird gelöst durch ein Leistungselektronikmodulsystem, gemäß den Merkmalen des Anspruchs 1.

Vorteilhafte Ausbildungen der Erfindung ergeben sich aus den abhängigen Ansprüchen.

Es erweist sich als vorteilhaft, wenn der Kühlkanal innerhalb einer in axialer Richtung des Leistungselektronikmoduls verlaufenden ersten Seitenwand des Aufnahmebereichs verläuft und weiter durch den Stromrichterkühlbereich verläuft und weiter innerhalb einer in axialer Richtung des Leistungselektronikmoduls verlaufenden zweiten Seitenwand des Aufnahmebereichs verläuft, da hierdurch eine besonders gute Kühlung des Stromrichters und des Anschlussmoduls erzielt wird.

Weiterhin erweist sich als vorteilhaft, wenn der Kühlkanal an der ersten Seitenwand eine Eintrittsöffnung für das Kühlmedium und an der zweiten Seitenwand eine Austrittsöffnung für das Kühlmedium aufweist, da hierdurch eine besonders gute Kühlung des Stromrichters und des Anschlussmoduls erzielt wird.

Ferner erweist es sich als vorteilhaft, wenn der Kühlkanal in axialer Richtung des Leistungselektronikmoduls durch die erste und die zweite Seitenwand des Aufnahmebereichs verläuft, da hierdurch eine besonders gute Kühlung des Stromrichters und es Anschlussmoduls erzielt wird.

Weiterhin ist es vorgesehen, dass die ersten Kontaktelemente an einer dritten Seitenwand des Aufnahmebereichs anordnet sind, wobei die ersten Kontaktelemente eine thermisch leitfähige Verbindung mit der dritten Seitenwand des Aufnahmebereichs aufweisen, wobei die dritte Seitenwand einen thermisch leitfähigen Kontakt mit der ersten und der zweiten Seitenwand des Aufnahmebereichs aufweist, da hierdurch eine besonders gute Kühlung des Stromrichters und des Anschlussmoduls erzielt wird und das Leistungselektronikmodul besonders einfach hergestellt werden kann.

Ferner erweist es sich als vorteilhaft, wenn das Anschlussmodul ein Gehäuse aufweist, wobei die geometrische Form des Gehäuses des Anschlussmoduls derart ausgebildet ist, dass wenn das Anschlussmodul im Aufnahmebereich angeordnet ist, die den ersten Kontaktelementen zugewandte Gehäuseseite des Anschlussmoduls einen thermisch leitfähigen Kontakt mit der Seitenwand des Aufnahmebereichs, welche eine thermisch leitfähige Verbindung mit den ersten Kontaktelementen aufweist, aufweist. Hierdurch eine besonders gute Kühlung des Anschlussmoduls erzielt.

Weiterhin erweist es sich als vorteilhaft, wenn das Anschlussmodul ein Gehäuse aufweist, wobei die geometrische Form des Gehäuses des Anschlussmoduls derart ausgebildet ist, dass wenn das Anschlussmodul im Aufnahmebereich angeordnet ist, die der ersten Seitenwand des Aufnahmebereichs zugewandte Gehäuseseite des Anschlussmoduls einen thermisch leitfähigen Kontakt mit der ersten Seitenwand des Aufnahmebereichs aufweist und die der zweiten Seitenwand des Aufnahmebereichs zugewandte Gehäuseseite des Anschlussmoduls einen thermisch leitfähigen Kontakt mit der zweiten Seitenwand des Aufnahmebereichs aufweist. Hierdurch eine besonders gute Kühlung des Anschlussmoduls erzielt.

Weiterhin erweist es sich als vorteilhaft, wenn das Anschlussmodul ein Gehäuse aufweist, wobei eine vierte Seitenwand des Aufnahmebereich den Aufnahmebereich vom Stromrichterkühlbereich trennt, wobei die geometrische Form des Gehäuses des Anschlussmoduls derart ausgebildet ist, dass wenn das Anschlussmoduls im Aufnahmebereich angeordnet ist, die der vierten Seitenwand des Aufnahmebereichs zugewandte Gehäuseseite des Anschlussmoduls einen thermisch leitfähigen Kontakt mit der vierten Seitenwand des Aufnahmebereichs aufweist. Hierdurch wird eine besonders gute Kühlung des Anschlussmoduls erzielt.

Ferner erweist es sich als vorteilhaft, wenn das Anschlussmodul ein Gehäuse aufweist, wobei die geometrische Form des Gehäuses des Anschlussmoduls derart ausgebildet ist, dass wenn das Anschlussmodul im Aufnahmebereich angeordnet ist, das Gehäuse des Anschlussmoduls formschlüssig mit dem Aufnahmebereich im Aufnahmebereich anordnet ist, da hierdurch eine optimale Kühlung des Anschlussmoduls erzielt wird.

Ferner erweist es sich als vorteilhaft, wenn das Verbinden des Anschlussmoduls mit dem Leistungselektronikmodul mittels einer Schraubverbindung realisiert ist, da eine Schraubverbindung besonders zuverlässig ist. Selbstverständlich kann das Verbinden des Anschlussmoduls mit dem Leistungselektronikmodul auch über andere Verbindungstypen, wie z.B. mittels einer Schnappverbindung, realisiert sein.

Weiterhin erweist es sich als vorteilhaft, wenn die Kühlvorrichtung ein erstes und ein zweites Hauptgehäuseteil aufweist, wobei der Kühlkanal im Stromrichterkühlbereich durch eine erste konturierte Oberfläche des ersten Hauptgehäuseteils und durch eine erste konturierte Oberfläche des zweiten Hauptgehäuseteils, die der ersten konturierten Oberfläche des ersten Hauptgehäuseteils gegenüberliegend angeordnet ist, gebildet wird. Hierdurch eine besonders gute Kühlung des Stromrichters erzielt.

Weiterhin erweist es sich als vorteilhaft, wenn der Aufnahmebereich einstückig mit dem ersten Hauptgehäuseteil ausgebildet ist. Hierdurch ein besonders einfacher Aufbau des Leistungselektronikmoduls erzielt.

Ferner erweist es sich als vorteilhaft, wenn der erste Stromrichter im ersten Hauptgehäuseteil angeordnet ist und eine thermisch leitfähige Verbindung zum ersten Hauptgehäuseteil aufweist. Hierdurch eine besonders gute Kühlung des Stromrichters erzielt.

Ferner erweist es sich als vorteilhaft, wenn das Leistungselektronikmodul einen zweiten Stromrichter aufweist, wobei der zweite Stromrichter im zweiten Hauptgehäuseteil angeordnet ist und eine thermisch leitfähige Verbindung zum zweiten Hauptgehäuseteil aufweist. Hierdurch eine besonders gute Kühlung der beiden Stromrichter erzielt.

Weiterhin erweist es sich ein Elektrofahrzeug, das mit einem Elektromotor angetrieben wird und zur Ansteuerung des Elektromotors ein erfindungsgemäßes Leistungselektronikmodulsystem aufweist als vorteilhaft. Das Elektrofahrzeug kann z.B. als Auto, LKW, Fahrrad, Schiff oder U-Boot ausgebildet sein. Selbstverständlich kann die Erfindung aber auch bei beliebigen anderen Anwendungen, insbesondere auch bei Anwendungen, die nicht der Automobilindustrie zugehören, angewendet werden.

Eine Ausführungsform der Erfindung ist in den Figuren dargestellt und wird im Folgenden näher erläutert. Dabei zeigen:
- FIG 1: ein erfindungsgemäßes Leistungselektronikmodulsystem in einer schematisierten perspektivischen Ansicht von oben, auf das Leistungselektronikmodulsystem,
- FIG 2: ein erfindungsgemäßes Leistungselektronikmodulsystem in einer schematisierten perspektivischen Ansicht von unten, auf das Leistungselektronikmodulsystem und
- FIG 3: ein Leistungselektronikmodul des erfindungsgemäßen Leistungselektronikmodulsystems in einer schematisierten Ansicht von oben, auf das Leistungselektronikmodul, sowie zwei schematisierte Schnittansichten des Leistungselektronikmoduls.

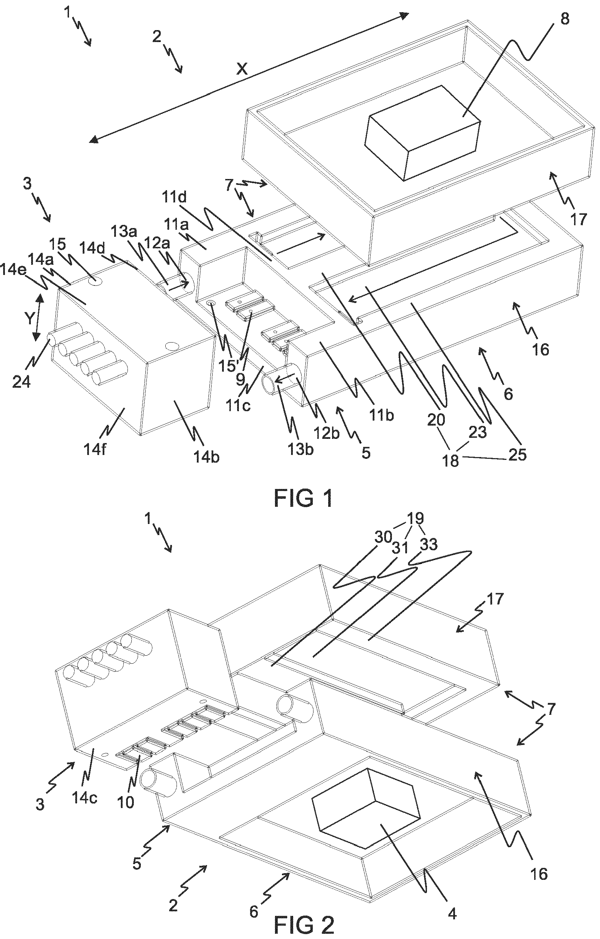

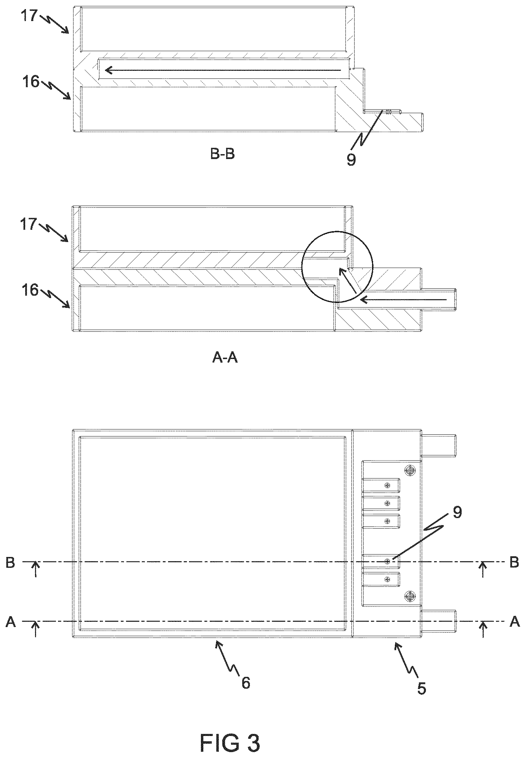

In FIG 1, FIG 2 und FIG 3 sind dabei der Übersichtlichkeit halber nur die zum Verständnis der Erfindung wesentlichen Elemente des Leistungselektronikmodulsystems 1 dargestellt. In FIG 2 und FIG 3 sind gleiche Elemente mit den gleichen Bezugszeichen versehen wie in FIG 1.

Das erfindungsgemäße Leistungselektronikmodulsystem 1 weist ein Leistungselektronikmodul 2 und zur Herstellung von elektrisch leitenden Laststromverbindungen zwischen elektrischen Laststromleitungen 24 und dem Leistungselektronikmodul 2 ein mit dem Leistungselektronikmodul 2 verbindbares Anschlussmodul 3 auf. In der FIG 1 ist der Übersichtlichkeit halber nur eine Lastromleitung 24 mit einem Bezugszeichen versehen. Die Lastromleitungen 24 liegen im Rahmen des Ausführungsbeispiels in Form von Kabeln vor. Die Lastromleitungen 24 leiten den Laststrom und sind im Rahmen des Ausführungsbeispiels mit einem Elektromotor und einer Batterie, die der Energieversorgung des Elektromotors dient, elektrisch leitend verbunden, was der Übersichtlichkeit halber in den Figuren nicht dargestellt ist. Innerhalb des Anschlussmoduls 3 sind die Lastromleitungen 24 mit jeweilig zugehörigen elektrisch leitenden zweiten Kontaktelementen 10 (siehe FIG 2) elektrisch leitend verbunden. In der FIG 2 ist der Übersichtlichkeit halber nur ein zweites Kontaktelement 10 mit einem Bezugszeichen versehen. Das Leistungselektronikmodul 2 weist eine axiale Richtung X auf.

Im Rahmen des Ausführungsbeispiels weist das Leistungselektronikmodul 2 einen ersten Stromrichter 4, einen zweiten Stromrichter 8 und eine Kühlvorrichtung 7 auf, wobei die Kühlvorrichtung 7 einen Stromrichterkühlbereich 6 und einen an einem axialen Ende des Leistungselektronikmoduls 2 angeordneten Aufnahmebereich 5 zur Aufnahme des Anschlussmoduls 3 aufweist. Der erste und der zweite Stromrichter sind dabei im Stromrichterkühlbereich 6 angeordnet. Selbstverständlich kann das Leistungselektronikmodul 2 aber auch nur einen einzelnen Stromrichter oder mehr Stromrichter als die beiden im Ausführungsbeispiel vorhandenen Stromrichter aufweisen.

Der Aufnahmebereich 5 weist im Rahmen des Ausführungsbeispiels eine erste Seitenwand 11a, eine zweite Seitenwand 11b, eine dritte Seitenwand 11c und eine vierte Seitenwand 11d auf. Die erste und die zweite Seitenwand sind zueinander parallel angeordnet. Die Seitenwände weisen eine Dicke auf und bilden den Aufnahmebereich 3 aus. Die dritte Seitenwand 11c weist einen thermischen leitfähigen Kontakt mit der ersten und der zweiten Seitenwand 11a und 11b des Aufnahmebereichs auf. Im Rahmen des Ausführungsbeispiels trennt die vierte Seitenwand 11d den Aufnahmebereich 5 vom Stromrichterkühlbereich 6 und weist einen thermischen leitfähigen Kontakt mit der ersten, zweiten und dritten Seitenwand 11a, 11b und 11c auf. Die erste, zweite und dritte Seitenwand 11a, 11b und 11c verlaufen in axiale Richtung X des Leistungselektronikmoduls 2. Der Aufnahmebereich 5 ist vorzugsweise einstückig ausgebildet, so dass ein sehr guter thermisch leitfähiger Kontakt zwischen der ersten, zweiten, dritten und vierten Seitenwand 11a, 11b, 11c und 11d des Aufnahmebereichs 5 besteht.

Der Aufnahmebereich weist elektrisch leitende erste Kontaktelemente 9 auf, welche im Rahmen des Ausführungsbeispiels eine thermisch leitfähige Verbindung mit der dritten Seitenwand 11c des Aufnahmebereichs 5 aufweisen. Die Kontaktelemente 9 sind zur Realisierung der thermisch leitfähigen Verbindung auf der dritten Seitenwand 11c angeordnet, wobei zwischen den Kontaktelementen 9 und der dritten Seitenwand 11c ein elektrisch isolierendes thermisch leitfähiges Material (z.B. Keramik) angeordnet ist. Die Kontaktelemente 9 weisen vorzugsweise eine flache geometrische Form aus, so dass ein flächiger thermisch leitfähiger Kontakt zwischen den Kontaktelementen 9 und der dritten Seitenwand 11c besteht. Das elektrisch isolierende thermisch leitfähige Material ist dabei der Übersichtlichkeit halber in den Figuren nicht dargestellt.

Das Anschlussmodul 3 weist elektrisch leitende zweite Kontaktelemente 10 auf, die derart am Anschlussmodul 3 angeordnet sind, dass beim Anordnen des Anschlussmoduls 3 im Aufnahmebereich 5 ein elektrisch leitender Kontakt zwischen den ersten und den zweiten Kontaktelementen 9 und 10 entsteht. Die ersten und zweiten Kontaktelemente 9 und 10 sind beim Anordnen des Anschlussmoduls 3 im Aufnahmebereich 5 zueinander gegenüberliegend angeordnet.

Das Anschlussmodul 3 weist ein Gehäuse auf, wobei im Rahmen des Ausführungsbeispiels, wenn das Anschlussmoduls 2 im Aufnahmebereich 5 angeordnet ist, die den ersten Kontaktelementen 9 zugewandte Gehäuseseite 14c des Anschlussmoduls 3 einen thermisch leitfähigen Kontakt mit der dritten Seitenwand 11c des Aufnahmebereichs 5 aufweist. Im Rahmen des Ausführungsbeispiels sind die zweiten Kontaktelemente 10, wenn das Anschlussmoduls 2 im Aufnahmebereich 5 angeordnet ist, in Richtung des Anschlussmoduls 3 versenkt an der den ersten Kontaktelementen 9 zugewandten Gehäuseseite 14c des Anschlussmoduls 3 angeordnet.

Die geometrische Form des Gehäuses des Anschlussmoduls ist vorzugsweise derart ausgebildet ist, dass wenn das Anschlussmoduls 2 im Aufnahmebereich 5 angeordnet ist, die der ersten Seitenwand 11a des Aufnahmebereichs 5 zugewandte Gehäuseseite 14a des Anschlussmoduls 3 einen thermisch leitfähigen Kontakt mit der ersten Seitenwand 11a des Aufnahmebereichs 5 aufweist und die der zweiten Seitenwand 11b des Aufnahmebereichs 5 zugewandte Gehäuseseite 14b des Anschlussmoduls 3 einen thermisch leitfähigen Kontakt mit der zweiten Seitenwand 11b des Aufnahmebereichs 2 aufweist.

Die geometrische Form des Gehäuses des Anschlussmoduls 3 ist weiterhin im Rahmen des Ausführungsbeispiels derart ausgebildet ist, dass wenn das Anschlussmodul 3 im Aufnahmebereich 5 angeordnet ist, die der vierten Seitenwand 11d des Aufnahmebereichs 5 zugewandte Gehäuseseite 14d des Anschlussmoduls 3 einen thermisch leitfähigen Kontakt mit der vierten Seitenwand 11d des Aufnahmebereichs 5 aufweist.

Die thermisch leitfähigen Kontakte zwischen den Gehäuseseiten des Anschlusselements und den Seitenwänden des Aufnahmebereichs sind dabei im Rahmen des Ausführungsbeispiels in Form von mechanischen Kontakten zwischen den Gehäuseseiten des Anschlusselements und den Seitenwänden des Aufnahmebereichs realisiert, so dass im Rahmen des Ausführungsbeispiels die geometrische Form des Gehäuses des Anschlussmoduls derart ausgebildet ist, dass wenn das Anschlussmodul im Aufnahmebereich angeordnet ist, das Gehäuse des Anschlussmoduls formschlüssig mit dem Aufnahmebereich im Aufnahmebereich anordnet ist.

Das Verbinden des Anschlussmoduls mit dem Leistungselektronikmodul ist im Rahmen des Ausführungsbeispiels mittels einer Schraubverbindung realisiert ist. Das Anschlusselement weist hierzu zwei durch das Anschlusselement verlaufende Durchgangsbohrungen 15 und der Aufnahmebereich zwei mit Innengewinden versehene Löcher 15' auf. Zur Verbindung des Anschlussmoduls mit dem Leistungselektronikmodul werden die Schrauben durch die Durchgangsbohrungen 15 geführt und mit den Löchern 15' verschraubt.

Erfindungsgemäß verläuft innerhalb mindestens einer der Seitenwände 11a, 11b, 11c und 11d des Aufnahmebereichs 5 ein von einem flüssigen Kühlmedium, wie z.B. Wasser, durchfließbarer Kühlkanal und verläuft weiter durch den Stromrichterkühlbereich 6. Mittels des gemeinsamen Kühlkanals des Aufnahmebereichs 5 und des Stromrichterkühlbereich 6 wird sowohl der Aufnahmebereich 5 als auch der Stromrichterkühlbereich 6 gekühlt. Der Aufnahmebereichs 5 ist dabei an einem axialen Ende des Leistungselektronikmoduls 2 angeordnet und durch eine Seitenwand des Aufnahmebereichs vom Leistungselektronikmodul 2 getrennt. Die Wärme der Lastromleitungen 24 wird über die elektrisch leitenden ersten und zweiten Kontaktelemente an den Aufnahmebereich 5 übertragen und vom Aufnahmebereich 5 an das Kühlmedium, das durch den, durch den Aufnahmebereich 5 hindurchgehenden Kühlkanal fließt, aufgenommen. Die Wärme der Lastromleitungen 24 gelangt somit nicht mehr, wie bei einem fachüblichen Leistungselektronikmodul, zu dem ersten und zweiten Stromrichter. Weiterhin wird auch die in den ersten und zweiten Kontaktelementen entstehende Wärme nicht mehr an die Stromrichter übertragen, sondern wird ebenfalls vom Kühlmedium, das durch den, durch den Aufnahmebereich 5 hindurchgehenden Kühlkanal fließt, aufgenommen. Somit gelangt auch diese Wärme bei dem erfindungsgemäßen Leistungselektronikmodulsystem nicht zu dem ersten und zweiten Stromrichter. Weiterhin wird auch das Anschlussmodul 3, infolge der thermisch leitenden Kontakte, mit den Seitenwänden des Aufnahmebereichs 5 gekühlt, so dass eine Überhitzung des Anschlussmoduls 3 durch die Erfindung zuverlässig vermieden wird.

Im Rahmen des Ausführungsbeispiels verläuft dabei der Kühlkanal innerhalb der in axialen Richtung X des Leistungselektronikmoduls 2 verlaufenden ersten Seitenwand 11a des Aufnahmebereichs 5 und verläuft weiter durch den Stromrichterkühlbereich 6 und von dort weiter innerhalb der in axialen Richtung X des Leistungselektronikmoduls 2 verlaufenden zweiten Seitenwand 11b des Aufnahmebereichs 5. Der Kühlkanal verläuft somit in axiale Richtung X des Leistungselektronikmoduls 2 durch die erste und die zweite Seitenwand 11a und 11b des Aufnahmebereichs 5. Im Rahmen des Ausführungsbeispiels weist der Kühlkanal an der ersten Seitenwand 11a eine vorzugsweise in axiale Richtung X geöffnete Eintrittsöffnung 12a für das Kühlmedium und an der zweiten Seitenwand 11b eine vorzugsweise in axiale Richtung X geöffnete Austrittsöffnung 12b für das Kühlmedium auf. In FIG 1 und FIG 3 ist der Fluss des Kühlmediums durch den Kühlkanal mittels Pfeilen dargestellt.

Die Kühlvorrichtung 7 weist im Rahmen des Ausführungsbeispiels ein erstes Hauptgehäuseteil 16 und ein zweites Hauptgehäuseteil 17 auf, wobei der Kühlkanal im Stromrichterkühlbereich 6 durch eine erste konturierte Oberfläche 18 des ersten Hauptgehäuseteils 16 und durch eine erste konturierte Oberfläche 19 des zweiten Hauptgehäuseteils 17, die der ersten konturierten Oberfläche 18 des ersten Hauptgehäuseteils 16 gegenüberliegend angeordnet ist, gebildet wird. Die erste konturierte Oberfläche 18 weist eine erste Vertiefung 23, die eine derartige Form ausweist, dass sich ein erster Steg 20 bildet um den das Kühlmedium fließt, sowie einen ersten Randbereich 25 auf. Die erste konturierte Oberfläche 19 des zweiten Hauptgehäuseteils 17 weist eine zweite Vertiefung 31 auf, die eine derartige Form ausweist, dass sich ein zweiter Steg 30 bildet um den das Kühlmedium fließt, sowie einen zweiten Randbereich 33 auf. In FIG 1 und FIG 2 ist der Übersichtlichkeit halber das erste Hauptgehäuseteil 16 und das zweite Hauptgehäuseteil 17 voneinander beanstandet dargestellt.

Der Aufnahmebereich 5 ist im Rahmen des Ausführungsbeispiels einstückig mit dem ersten Hauptgehäuseteil 16 ausgebildet.

Der erste Stromrichter 4 ist im Rahmen des Ausführungsbeispiels im ersten Hauptgehäuseteil 16 angeordnet ist und weist eine thermisch leitfähige Verbindung zum ersten Hauptgehäuseteil 16 auf. Der erste Stromrichter 16 ist dabei vorzugsweise elektrisch isoliert vom ersten Hauptgehäuseteil 16 angeordnet.

Der zweite Stromrichter 8 ist im Rahmen des Ausführungsbeispiels im zweiten Hauptgehäuseteil 17 angeordnet und weist eine thermisch leitfähige Verbindung zum zweiten Hauptgehäuseteil 17 auf. Der zweite Stromrichter 8 ist dabei vorzugsweise elektrisch isoliert vom zweiten Hauptgehäuseteil 17 angerordnet. Der erste und der zweite Stromrichter sind in FIG 1 und FIG 2 stark schematisiert in Form eines Quaders dargestellt.

In FIG 3 ist der Übersichtlichkeit halber der erste und der zweite Stromrichter nicht dargestellt. Der erste und der zweite Stromrichter weisen Halbleiterschalter, z.B. in Form von IGBTs, MOSFETS oder Thyristoren, auf. Der erste und der zweite Stromrichter können z.B. zusammengenommen einen Wechselrichter oder einen Gleichrichter bilden. Weiterhin können z.B. der erste und der zweite Stromrichter zusammengenommen einen Umrichter bilden. Selbstverständlich kann aber auch nur ein erster Stromrichter vorhanden sein, der z.B. einen Wechselrichter, Gleichrichter oder einen Umrichter bildet.

Die Lastromleitungen 24 und deren Zuleitungsrichtung zum Leitungselektronikmodul 2 sind, insbesondere in der Automobilindustrie, bei den einzelnen Automobilherstellern unterschiedlich ausgestaltet, so dass bisher zur Herstellung der elektrisch leitenden Laststromverbindungen zwischen den elektrischen Laststromleitungen und dem Leistungselektronikmodul die elektrischen Lastanschlüsse des Leitungselektronikmoduls individuell an die Erfordernisse des betreffenden Automobilhersteller angepasst werden müssen, was einen hohen Aufwand erfordert.

Im Rahmen des Ausführungsbeispiels verläuft die Zuleitungsrichtung der Lastromleitungen 24 zum Leitungselektronikmodul 2 in axiale Richtung X, so dass die Lastromleitungen 24 in axiale Richtung X in das Anschlussmodul 3 einmünden. Beim Ausführungsbeispiels weist deshalb die der vierten Seitenwand 11d abgewandte Gehäuseseite 14f des Anschlussmoduls 3 Öffnungen zur Durchführung der Lastromleitungen 24 auf. Wenn z.B. ein anderer Automobilhersteller die Zuleitungsrichtung der Lastromleitungen 24 zum Leitungselektronikmodul 2 in Richtung Y in FIG 1 von oben auf das Leitungselektronikmodul 2 zu wünscht, weil er z.B. das Leitungselektronikmodul 2 im Motorraum anders angeordnet hat, dann muss lediglich das Anschlussmodul 3 gegen einen Anschlussmodul, dass die Öffnungen zur Durchführung der Lastromleitungen 24 an der der dritten Seitenwand 11c abgewandten Gehäuseseite 14e des Anschlussmoduls 3 aufweist, ausgetauscht werden. Das Leitungselektronikmodul 2 muss nicht verändert werden. Somit kann das Leitungselektronikmodul 2, z.B. für unterschiedliche Automobilhersteller, einheitlich verwendet und hergestellt werden.

Es sei an dieser Stelle angemerkt, dass der Übersichtlichkeit halber in den Figuren die elektrischen Verbindungen zwischen den ersten Kontaktelementen 9 und dem ersten und zweiten Stromrichter 4 und 8 nicht dargestellt sind.

## Patentansprüche

1. Leistungselektronikmodulsystem, wobei das Leistungselektronikmodulsystem (1) ein Leistungselektronikmodul (2), ein mit dem Leistungselektronikmodul (2) verbindbares, Anschlussmodul (3), eine Kühlvorrichtung (7) und einen an einem axialen Ende des Leistungselektronikmoduls (2) angeordneten Aufnahmebereich (5) zur Aufnahme des Anschlussmoduls (3) aufweist, wobei der Aufnahmebereich (5) Seitenwände (11a, 11b, 11c, 11d) aufweist, wobei der Aufnahmebereich (5) elektrisch leitende erste Kontaktelemente (9) aufweist, welche eine thermisch leitfähige Verbindung mit einer Seitenwand (11c) des Aufnahmebereichs (5) aufweisen, wobei das Anschlussmodul (3) elektrisch leitende zweite Kontaktelemente (10) aufweist, die derart am Anschlussmodul (3) angeordnet sind, dass beim Anordnen des Anschlussmoduls (3) im Aufnahmebereich (5) ein elektrisch leitender Kontakt zwischen den ersten und den zweiten Kontaktelementen (9, 10) entsteht, wobei innerhalb mindestens einer der Seitenwände (11a, 11b, 11c, 11d) des Aufnahmebereichs (5) ein von einem flüssigen Kühlmedium durchfließbarer Kühlkanal verläuft und weiter durch den Stromrichterkühlbereich (6) verläuft, **dadurch gekennzeichnet, dass** der Kühlkanal derart innerhalb einer in axialer Richtung (X) des Leistungselektronikmoduls (2) verlaufenden ersten Seitenwand (11a) des Aufnahmebereichs (5) und weiter innerhalb einer in axialer Richtung (X) des Leistungselektronikmoduls (2) verlaufenden zweiten Seitenwand (11b) des Aufnahmebereichs (5) verläuft, wobei das Anschlussmodul (3) ein Gehäuse aufweist, wobei die geometrische Form des Gehäuses des Anschlussmoduls (3) derart ausgebildet ist, dass, wenn das Anschlussmodul (3) im Aufnahmebereich (5) angeordnet ist, die der ersten Seitenwand (11a) des Aufnahmebereichs (5) zugewandte Gehäuseseite (14a) des Anschlussmoduls (3) einen thermisch leitfähigen Kontakt mit der ersten Seitenwand (11a) des Aufnahmebereichs (5) aufweist und die der zweiten Seitenwand (11b) des Aufnahmebereichs (5) zugewandte Gehäuseseite (14b) des Anschlussmoduls (3) einen thermisch leitfähigen Kontakt mit der zweiten Seitenwand (11b) des Aufnahmebereichs (5) aufweist, wobei die ersten Kontaktelemente (9) an einer dritten Seitenwand (11c) des Aufnahmebereichs (5) anordnet sind, wobei die ersten Kontaktelemente (9) eine thermisch leitfähige Verbindung mit der dritten Seitenwand (11c) des Aufnahmebereichs (5) aufweisen, wobei die dritte Seitenwand (11c) einen thermischen leitfähigen Kontakt mit der ersten und der zweiten Seitenwand (11a, 11b) des Aufnahmebereichs aufweist und wobei die ersten Kontaktelemente (9) auf der dritten Seitenwand (11c) angeordnet sind und wobei zwischen den ersten Kontaktelementen (9) und der dritten Seitenwand (11c) ein thermisch leitfähiges Material angeordnet ist.

2. Leistungselektronikmodulsystem nach Anspruch 1, **dadurch gekennzeichnet, dass** der Kühlkanal an der ersten Seitenwand (11a) eine Eintrittsöffnung (12a) für das Kühlmedium und an der zweiten Seitenwand (11b) eine Austrittsöffnung (12b) für das Kühlmedium aufweist.

3. Leistungselektronikmodulsystem nach Anspruch 1 oder 2, **dadurch gekennzeichnet, dass** der Kühlkanal in axiale Richtung (X) des Leistungselektronikmoduls (2) durch die erste und die zweite Seitenwand (11a, 11b) des Aufnahmebereichs (5) verläuft.

4. Leistungselektronikmodulsystem nach Anspruch 3, **dadurch gekennzeichnet, dass** die dritte Seitenwand (11c) in axialer Richtung des Leistungselektronikmoduls (2) verläuft.

5. Leistungselektronikmodulsystem nach einem der vorhergehenden Ansprüche, **dadurch gekennzeichnet, dass** der Aufnahmebereich (5) einstückig ausgebildet ist.

6. Leistungselektronikmodulsystem nach einem der vorhergehenden Ansprüche, **dadurch gekennzeichnet, dass** das Anschlussmodul (3) ein Gehäuse aufweist, wobei die geometrische Form des Gehäuses des Anschlussmoduls (3) derart ausgebildet ist, dass, wenn das Anschlussmodul (3) im Aufnahmebereich (5) angeordnet ist, die den ersten Kontaktelementen (9) zugewandte Gehäuseseite des Anschlussmoduls (3) einen thermisch leitfähigen Kontakt mit der Seitenwand (11c) des Aufnahmebereichs, welche eine thermisch leitfähige Verbindung mit den ersten Kontaktelementen (9) aufweist, aufweist.

7. Leistungselektronikmodulsystem nach einem der vorhergehenden Ansprüche, **dadurch gekennzeichnet, dass** das Anschlussmodul (3) ein Gehäuse aufweist, wobei eine vierte Seitenwand (11d) des Aufnahmebereichs (5) den Aufnahmebereich (5) vom Stromrichterkühlbereich (6) trennt, wobei die geometrische Form des Gehäuses des Anschlussmoduls (3) derart ausgebildet ist, dass, wenn das Anschlussmodul (3) im Aufnahmebereich (5) angeordnet ist, die der vierten Seitenwand (11d) des Aufnahmebereichs (5) zugewandte Gehäuseseite (14d) des Anschlussmoduls (3) einen thermisch leitfähigen Kontakt mit der vierten Seitenwand (11d) des Aufnahmebereichs (5) aufweist.

8. Leistungselektronikmodulsystem nach einem der vorhergehenden Ansprüche, **dadurch gekennzeichnet, dass** das Anschlussmodul (3) ein Gehäuse aufweist, wobei die geometrische Form des Gehäuses des Anschlussmoduls (3) derart ausgebildet ist, dass, wenn das Anschlussmodul (3) im Aufnahmebereich (5) angeordnet ist, das Gehäuse des Anschlussmoduls (3) formschlüssig mit dem Aufnahmebereich (5) im Aufnahmebereich (5) anordnet ist.

9. Leistungselektronikmodulsystem nach einem der vorhergehenden Ansprüche, **dadurch gekennzeichnet, dass** das Verbinden des Anschlussmoduls (3) mit dem Leistungselektronikmodul (6) mittels einer Schraubverbindung realisiert ist.

10. Leistungselektronikmodulsystem nach einem der vorhergehenden Ansprüche, **dadurch gekennzeichnet, dass** die Kühlvorrichtung (7) ein erstes und ein zweites Hauptgehäuseteil (16, 17) aufweist, wobei der Kühlkanal im Stromrichterkühlbereich (6) durch eine erste konturierte Oberfläche (18) des ersten Hauptgehäuseteils (16) und durch eine erste konturierte Oberfläche (19) des zweiten Hauptgehäuseteils (17), die der ersten konturierten Oberfläche (18) des ersten Hauptgehäuseteils (16) gegenüberliegend angeordnet ist, gebildet wird.

11. Leistungselektronikmodulsystem nach Anspruch 10, **dadurch gekennzeichnet, dass** der Aufnahmebereich (5) einstückig mit dem ersten Hauptgehäuseteil (16) ausgebildet ist.

12. Leistungselektronikmodulsystem nach Anspruch 10 oder 11, **dadurch gekennzeichnet, dass** der erste Stromrichter (4) im ersten Hauptgehäuseteil (16) angeordnet ist und eine thermisch leitfähige Verbindung zum ersten Hauptgehäuseteil (16) aufweist.

13. Leistungselektronikmodulsystem nach einem der Ansprüche 10 bis 12, **dadurch gekennzeichnet, dass** das Leistungselektronikmodul (2) einen zweiten Stromrichter (8) aufweist, wobei der zweite Stromrichter (8) im zweiten Hauptgehäuseteil (17) angeordnet ist und eine thermisch leitfähige Verbindung zum zweiten Hauptgehäuseteil (17) aufweist.

14. Elektrofahrzeug, **dadurch gekennzeichnet, dass** das Elektrofahrzeug mit einem Elektromotor angetrieben wird und zur Ansteuerung des Elektromotors ein Leistungselektronikmodulsystem (1) nach einem der vorhergehenden Ansprüche aufweist.

## Claims

1. A power electronics module system, wherein the power electronics module system (1) comprises a power electronics module (2), a connection module (3) connectable to the power electronics module (2), a cooling apparatus (7) and a reception area (5) arranged at an axial end of the power electronics modules (2) for receiving the connection module (3), wherein the reception area (5) comprises lateral walls (11a, 11b, 11c, 11d), wherein the reception area (5) comprises electrically conductive first contact elements (9), which comprise a thermically conductible connection to a lateral wall (11c) of the reception area (5), wherein the connection module (3) comprises electrically conductive second contact elements (10), which are arranged on the connection module (3) such that, upon arranging the connection module (3) within the reception area (5), an electrically conductive contact between the first and the second contact elements (9, 10) is provided, wherein, within at least one of the lateral walls (11a, 11b, 11c, 11d) of the reception area (5), a cooling channel able to be flown through by a liquid cooling medium extends und further passing across the rectifier cooling area (6), **characterized in that** the cooling channel extends within a first lateral wall (11a) of the reception area (5) extending in an axial direction (X) of the power electronics module (2) and further extends within a second lateral wall (11b) of the reception area (5) extending in an axial direction (X) of the power electronics module (2), wherein the connection module (3) comprises a housing, wherein the geometrical shape of the housing of the connection module (3) is formed such that, if the connection module (3) is arranged in the reception area (5), the connection module (3) housing side (14a) facing the first lateral wall (11a) of the receiving area (5) comprises a thermically conductive contact with the first lateral wall (11a) of the receiving area (5) and the connection module (3) housing side (14b) facing the second lateral wall (11b) of the receiving area (5) comprises a thermically conductive contact with the second lateral wall (11b) of the receiving area (5), wherein the first contact elements (9) are arranged on a third lateral wall (11c) of the receiving area (5), wherein the first contact elements (9) comprise a thermically conductive connection to the third lateral wall (11c) of the receiving area (5), wherein the third lateral wall (11c) comprises a thermically conductive contact with the first and second lateral wall (11a, 11b) of the receiving area and wherein the first contact elements (9) are arranged on the third lateral wall (11c) and wherein a thermically conductive material is arranged between the first contact elements (9) and the third lateral wall (11c).

2. The power electronics module system according to claim 1, **characterized in that** the cooling channel, on the first lateral wall (11a), comprises an entrance window (12a) for the cooling medium and, on the second lateral wall (11b), comprises an exit window (12b) for the cooling medium.

3. The power electronics module system according to claim 1 or 2, **characterized in that** the cooling channel extends in an axial direction (X) of the power electronics module (2) across the first and the second lateral wall (11a, 11b) of the reception area (5).

4. The power electronics module system according to claim 3, **characterized in that** the third lateral wall (11c) extends in an axial direction of the power electronics module (2).

5. The power electronics module system according to one of the preceding claims, **characterized in that** the reception area (5) is integrally formed.

6. The power electronics module system according to one of the preceding claims, **characterized in that** the connection module (3) comprises a housing wherein the geometrical shape of the housing of the connection module (3) is formed such that, if the connection module (3) is arranged in the reception area (5), the housing side of the connection module (3) facing the first contact elements (9) comprises a thermically conductive contact with the lateral wall (11c) of the reception area, which comprises a thermically conductible connection to the first contact elements (9).

7. The power electronics module system according to one of the preceding claims, **characterized in that** the connection module (3) comprises a housing, wherein a fourth lateral wall (11d) of the reception area (5) separates the reception area (5) from the rectifier cooling area (6), wherein the geometrical shape of the housing of the connection module (3) is formed such that, if the connection module (3) is arranged in the reception area (5), the housing side (14d) of the connection module (3) facing the fourth lateral wall (11d) of the reception area (5) comprises a thermically conductible contact with the fourth lateral wall (11d) of the reception area (5).

8. The power electronics module system according to one of the preceding claims, **characterized in that** the connection module (3) comprises a housing, wherein the geometrical shape of the housing of the connection module (3) is formed such that, if the connection module (3) is arranged in the reception area (5), the housing of the connection module (3) is form-fittingly arranged together with the reception area (5) in the reception area (5).

9. The power electronics module system according to one of the preceding claims, **characterized in that** connecting the connection module (3) to the power electronics module (6) is realized by means of a threaded connection.

10. The power electronics module system according to one of the preceding claims, **characterized in that** the cooling apparatus (7) comprises a first and a second main housing portion (16, 17), wherein the cooling channel in the rectifier cooling area (6) is formed by a first continuous surface (18) of the first main housing portion (16) and by a first contoured surface (19) of the second main housing portion (17), the first contoured surface being arranged opposite of the first contoured surface (18) of the first main housing portion (16).

11. The power electronics module system according to claim 10, **characterized in that** the reception area (5) is integrally formed with the first main housing portion (16).

12. The power electronics module system according to claim 10 or 11, **characterized in that** the first rectifier (4) is arranged in the first main housing portion (16) and comprises a thermically conductible connection to the first main housing portion (16).

13. The power electronics module system according to one of the claims 10 to 12, **characterized in that** the power electronics module (2) comprises a second rectifier (8), wherein the second rectifier (8) is arranged in the second main housing portion (17) and comprises a thermically conductible connection to the second main housing portion (17).

14. An electrical vehicle, **characterized in that** the electrical vehicle is driven by an electric motor and comprises a power electronics module system (1) according to one of the preceding claims for actuating the electric motor.

## Revendications

1. Système de module d'électronique de puissance, en ce que le système de module d'électronique de puissance (1) comporte un module d'électronique de puissance (2), un module de connexion (3) pouvant être raccordé au module d'électronique de puissance (2), un dispositif de refroidissement (7) et une zone de logement (5) disposée à une extrémité axiale du module d'électronique de puissance (2) destinée au logement du module de connexion (3), en ce que la zone de logement (5) comporte des parois latérales (11a, 11b, 11c, 11d), en ce que la zone de logement (5) comporte des premiers éléments de contact (9) électroconducteurs qui établissent une liaison thermoconductrice avec une paroi latérale (11c) de la zone de logement (5), en ce que le module de connexion (3) comporte des deuxièmes éléments de contact (10) électroconducteurs qui sont disposés sur le module de connexion (3) de telle manière que, lorsque le module de connexion (3) est disposé dans la zone de logement (5), il se forme un contact électroconducteur entre les premiers et les deuxièmes éléments de contact (9, 10), en ce qu'un canal de refroidissement pouvant être traversé par un réfrigérant liquide s'étend à l'intérieur d'au moins une des parois latérales (11a, 11b, 11c, 11d) de la zone de logement (5) et par ailleurs à travers la zone de refroidissement de convertisseur (6), **caractérisé en ce que** le canal de refroidissement s'étend de telle manière à l'intérieur d'une première paroi latérale (11a) de la zone de logement (5) s'étendant en sens axial (X) du module d'électronique de puissance (2) et par ailleurs à l'intérieur d'une deuxième paroi latérale (11b) de la zone de logement (5) s'étendant en sens axial (X) du module d'électronique de puissance (2), **en ce que** le module de connexion (3) comporte un boîtier, **en ce que** la forme géométrique du boîtier du module de connexion (3) est telle que, lorsque le module de connexion (3) est disposé dans la zone de logement (5), le côté de boîtier (14a) du module de connexion (3) tourné vers la première paroi latérale (11a) de la zone de logement (5) comporte un contact thermoconducteur avec la première paroi latérale (11a) de la zone de logement (5) et le côté de boîtier (14b) du module de connexion (3) tourné vers la deuxième paroi latérale (11b) de la zone de logement (5) comporte un contact thermoconducteur avec la deuxième paroi latérale (11b) de la zone de logement (5), **en ce que** les premiers éléments de contact (9) sont disposés au niveau d'une troisième paroi latérale (11c) de la zone de logement (5), **en ce que** les premiers éléments de contact (9) comportent une liaison thermoconductrice avec la troisième paroi latérale (11c) de la zone de logement (5), **en ce que** la troisième paroi latérale (11c) comporte un contact thermoconducteur avec la première et la deuxième paroi latérale (11a, 11b) de la zone de logement et **en ce que** les premiers éléments de contact (9) sont disposés sur la troisième paroi latérale (11c) et **en ce qu'**un matériau thermoconducteur est disposé entre les premiers éléments de contact (9) et la troisième paroi latérale (11c).

2. Système de module d'électronique de puissance selon la revendication 1, **caractérisé en ce que** le canal de refroidissement comporte au niveau de la première paroi latérale (11a) un orifice d'entrée (12a) pour le réfrigérant et au niveau de la deuxième paroi latérale (11b) un orifice de sortie (12b) pour le réfrigérant.

3. Système de module d'électronique de puissance selon la revendication 1 ou 2, **caractérisé en ce que** le canal de refroidissement dans le sens axial (X) du module d'électronique de puissance (2) passe par la première et la deuxième paroi latérale (11a, 11b) de la zone de logement (5).

4. Système de module d'électronique de puissance selon la revendication 3, **caractérisé en ce que** la troisième paroi latérale (11c) s'étend en sens axial du module d'électronique de puissance (2).

5. Système de module d'électronique de puissance selon l'une des revendications précédentes, **caractérisé en ce que** la zone de logement (5) est réalisée d'un seul tenant.

6. Système de module d'électronique de puissance selon l'une des revendications précédentes, **caractérisé en ce que** le module de connexion (3) comporte un boîtier, **en ce que** la forme géométrique du boîtier du module de connexion (3) est telle que, lorsque le module de connexion (3) est disposé dans la zone de logement (5), le côté de boîtier du module de connexion (3) tourné vers les premiers éléments de contact (9) comporte un contact thermoconducteur avec la paroi latérale (11c) de la zone de logement laquelle comporte une liaison thermoconductrice avec les premiers éléments de contact (9).

7. Système de module d'électronique de puissance selon l'une des revendications précédentes, **caractérisé en ce que** le module de connexion (3) comporte un boîtier, **en ce qu'**une quatrième paroi latérale (11d) de la zone de logement (5) sépare la zone de logement (5) de la zone de refroidissement de convertisseur (6), **en ce que** la forme géométrique du boîtier du module de connexion (3) est telle que, lorsque le module de connexion (3) est disposé dans la zone de logement (5), le côté de boîtier (14d) du module de connexion (3) tourné vers la quatrième paroi latérale (11d) de la zone de logement (5) comporte un contact thermoconducteur avec la quatrième paroi latérale (11d) de la zone de logement (5).

8. Système de module d'électronique de puissance selon l'une des revendications précédentes, **caractérisé en ce que** le module de connexion (3) comporte un boîtier, **en ce que** la forme géométrique du boîtier du module de connexion (3) est telle que, lorsque le module de connexion (3) est disposé dans la zone de logement (5), le boîtier du module de connexion (3) est disposé à liaison positive avec la zone de logement (5) dans la zone de logement (5).

9. Système de module d'électronique de puissance selon l'une des revendications précédentes, **caractérisé en ce que** la connexion du module de connexion (3) au module d'électronique de puissance (6) est réalisée au moyen d'un assemblage par vis.

10. Système de module d'électronique de puissance selon l'une des revendications précédentes, **caractérisé en ce que** le dispositif de refroidissement (7) comporte un premier et un deuxième élément de boîtier principal (16, 17), **en ce que** le canal de refroidissement dans la zone de refroidissement de convertisseur (6) est formé par une première surface profilée (18) du premier élément de boîtier principal (16) et par une première surface profilée (19) du deuxième élément de boîtier principal (17) qui est disposée à l'opposé de la première surface profilée (18) du premier élément de boîtier principal (16).

11. Système de module d'électronique de puissance selon la revendication 10, **caractérisé en ce que** la zone de logement (5) est réalisée d'un seul tenant avec le premier élément de boîtier principal (16).

12. Système de module d'électronique de puissance selon la revendication 10 ou 11, **caractérisé en ce que** le premier convertisseur (4) est disposé dans le premier élément de boîtier principal (16) et comporte une liaison thermoconductrice au premier élément de boîtier principal (16).

13. Système de module d'électronique de puissance selon l'une des revendications 10 à 12, **caractérisé en ce que** le module d'électronique de puissance (2) comporte un deuxième convertisseur (8), **en ce que** le deuxième convertisseur (8) est disposé dans le deuxième élément de boîtier principal (17) et comporte une liaison thermoconductrice au deuxième élément de boîtier principal (17).

14. Véhicule électrique, **caractérisé en ce que** le véhicule électrique est entraîné par un moteur électrique et comporte pour la commande du moteur électrique un système de module d'électronique de puissance (1) selon l'une des revendications précédentes.
